# EUROPEAN PATENT SPECIFICATION

(11) **EP 2 988 582 B1**
(45) Date of publication and mention of the grant of the patent: **18.09.2019**
(21) Application number: 13882423.0
(22) Date of filing: 18.04.2013
(51) Int. Cl.: H05K 13/00, H05K 3/12

(54) **SUBSTRATE-CLAMP DEVICE**
SUBSTRATKLEMMVORRICHTUNG
DISPOSITIF DE SERRAGE DE SUBSTRAT

(43) Date of publication of application: 24.02.2016
(73) Proprietor: FUJI Corporation, Chiryu Aichi (JP)
(72) Inventor: KAWAI, Hidetoshi, Chiryu, Aichi (JP); MIZUNO, Takayuki, Chiryu, Aichi (JP); ITO, Hidetoshi, Chiryu, Aichi (JP); TANAKA, Keita, Chiryu, Aichi (JP)
(74) Representative: Grünecker Patent- und Rechtsanwälte PartG mbB
(86) International application number: PCT/JP2013/061527
(87) International publication number: WO 2014/170993

(56) References cited:
- JP-A- H0 563 400
- JP-A- 2003 086 997
- JP-U- H0 388 399
- JP-U- S6 127 277
- US-A- 5 722 527
- US-A1- 2012 291 958

## Description

### Technical Field

The present invention relates to a board clamping apparatus in which a lateral end portion of a board transported by a conveyor is clamped between a lifting member and a holding member positioned above the lifting member.

### Background Art

In a typical component mounting machine, for example, a board conveyed by a conveyor is lifted by a lifting member of a board clamping apparatus from below at each side in a width direction of the conveyor such that a lateral end portion of the board is clamped between the lifting member and a holding member positioned above the lifting member, and then a component is mounted on the board by a mounting head. Boards of recent years become thinner and lower in strength, and thus the boards are easily warped. In addition, to satisfy a recent requirement of high-density mounting and downsizing, a demand of a double-sided mounting board which has components on each surface thereof is increasing. In the double-sided mounting board, first, components are mounted on one surface of the board and solder is thermally cured, and then the board is turned upside down and the other components are mounted on the other surface of the board and solder is thermally cured in the same manner. For such occasions, the board may be warped by heat of thermal curing.

If components are mounted on the warped board, mounting accuracy of the components is lowered, which results in deterioration of product quality. As described in JP-A-2004-335973 and Japanese Patent No. 2792931, the warpage of the board is corrected by a back-up pin that holds up a lower side of the board whose lateral end portions are clamped by a board clamping apparatus .

However, the back-up pin can only correct downward warpage (warpage in a downward direction) of the board and cannot correct upward warpage (warpage in an upward direction).

Then, WO01/058233 describes that a plurality of suction pads are disposed below the board such that the plurality of suction pads suck the board to correct the upward warpage of the board.

A board clamping apparatus according to the preamble of independent claim 1 is disclosed in US 5 722 527 A.

### Summary of Invention

### Technical Problem

However, as described in WO01/058233, if the plurality of suction pads are disposed below the board, the configuration of the apparatus become complex and costs increase. In addition, upward warpage of the board may not be corrected if a pre-mounted component on the lower surface of a double-sided mounting board interferes with the suction pads during mounting of the other components on the other surface of the board.

It is an object of the invention to provide a board clamping apparatus that reliably corrects upward warpage of a board while reducing the costs.

### Solution to Problem

To solve the above-described problem, the invention is directed to a board clamping apparatus in which a board conveyed by a conveyor is lifted by a lifting member from below at each side in a width direction of the board such that a lateral end portion of the board is clamped between the lifting member and a holding member positioned above the lifting member, the board clamping apparatus including an upward warpage correction means for correcting upward warpage of the board by applying a downward bending moment to the board by clamping the lateral end portion of the board between the lifting member and the holding member. In this configuration, since the lateral end portion of the board is clamped between the lifting member and the holding member such that the upward warpage correction means applies the downward bending moment to the board, the upward warpage of the board is reliably corrected by the downward bending moment. In addition, the upward warpage correction means does not interfere with a pre-mounted component that is mounted on the lower side of a double-sided mounting board even during correction of the upward warpage of the board, and thus the upward warpage of the board is reliably corrected. Furthermore, since the downward bending moment can be applied by clamping action of the lateral end portion of the board between the lifting member and the holding member, the configuration for correction of the upward warpage of the board is simplified, which reduces the costs.

Furthermore, the invention is configured such that the holding member is attached to be movable in the width direction between an upward warpage correction position and a normal clamping position with respect to each of guide rails positioned on both sides in a width direction of the conveyor, and the holding member clamps the board in a state that the downward bending moment is applied to the board by the upward warpage correction means at the upward warpage correction position, and clamps the board in a state that the downward bending moment is not applied to the board at the normal clamping position. With this configuration, when a board without upward warpage is clamped, the board can be clamped without being applied with the downward bending moment by moving the holding member to the normal clamping position.

In this case, the board clamping apparatus may be configured to include a position indicator for recognizing a position of the holding member, a camera that takes an image of the position indicator, and an image processing device that processes the image taken by the camera to recognize the position indicator and determine the position of the holding member. With this configuration, it can be confirmed whether the holding member is moved to the correct position or not during the production in advance.

Furthermore, the invention may be configured such that one holding member holds the entire area of the lateral end portion of the board or a plurality of separate holding members are disposed along the lateral end portion of the board and each of the plurality of separate holding members is attached to be movable between the upward warpage correction position and the normal clamping position individually. With this configuration, among the plurality of holding members disposed along the lateral end portion of the board, only the holding member that is positioned corresponding to an empty space in the lateral end portion of the board is moved to the upward warpage correction position for the upward warpage correction of the board. This minimizes dead space made by the holding member.

As a related example that is not an embodiment of the invention, the board clamping apparatus may be configured such that a holding member for upward warpage correction that clamps the board in a state that the downward bending moment is applied to the board by the upward warpage correction means is replaceable with a holding member for normal clamping that clamps the board in a state that the downward bending moment is not applied to the board.

Alternatively, as another related example that is not part of the invention, the board clamping apparatus may be configured to apply the downward bending moment to the board by detachably attaching an attachment for upward warpage correction that functions as the upward warpage correction means to a holding member for normal clamping that clamps the board in a state that the downward bending moment is not applied to the board. Any of the configurations can provide substantially the same effect.

In addition, it is preferable that the upward warpage correction means is configured such that a portion of a lower surface of the holding member that overlaps with the lateral end portion of the board is formed in a slope shape or a protrusion shape in which a distal end of the portion protrudes downwardly and, in a state that a lowest portion in the slope shape or the protrusion shape is positioned at an inner side of the board than the upper end of the lifting member, the lateral end portion of the board is nipped between the lowest portion and the upper end of the lifting member so that the downward bending moment is applied to the board. With this configuration, the downward bending moment can be applied to the board using a very simple configuration in which the portion in a slope shape or a step shape is provided on the lower surface of the holding member and the lowest portion of the portion is shifted from the upper end of the lifting member. This minimizes the costs.

### Brief Description of Drawings

Fig. 1 is a perspective view illustrating a component mounting station of a component mounting machine according to a first embodiment of the invention.
Fig. 2(a) is a vertical cross-sectional view of a main part and illustrates a state in which a holding member is positioned at a normal clamping position and a lifting member is positioned at a board unclamping position (conveying position), and Fig. 2(b) is a vertical cross-sectional view of the main part and illustrates a state in which the holding member is positioned at the normal clamping position and the lifting member is positioned at a board clamping position.
Fig. 3(a) is a vertical cross-sectional view of the main part and illustrates a state in which the holding member is positioned at an upward warpage correction position and the lifting member is positioned at the board unclamping position (conveying position), and Fig. 3(b) is a vertical cross-sectional view of the main part and illustrates a state in which the holding member is positioned at the upward warpage correction position and the lifting member is positioned at the board clamping position.
Fig. 4 is a vertical cross-sectional view of the main part for explaining an operation in which the upward warpage of the board is corrected.
Fig. 5(a) is a perspective view showing engagement between an engagement groove of the holding member and an engagement pin, and Fig. 5(b) is a plain view of the same.
Fig. 6 illustrates top views and vertical cross-sectional views showing states in which the position of the holding member is switched to (a) the upward warpage correction position, (b) the normal clamping position, and (c) a board removal position.
Fig. 7 is a perspective view illustrating a component mounting station of a component mounting machine according to a second embodiment of the invention.
Fig. 8(a) is a vertical cross-sectional view of the main part and illustrates a state of upward warpage correction according to a first related example that is not part of the invention, and Fig. 8(b) is a vertical cross-sectional view of the main part and illustrates a state of normal clamping.
Fig. 9(a) is a vertical cross-sectional view of the main part and illustrates a state of upward warpage correction according to a second related example that is not part of the invention, and Fig. 9(b) is a vertical cross-sectional view of the main part and illustrates a state of normal clamping.

### Description of Embodiments

Hereinafter, descriptions will be given regarding two embodiments including first and second embodiments in which aspects of the invention are embodied. Descriptions of related examples including first and second related examples that are not claimed but that are nonetheless useful for understanding the present invention are also given.

### First Embodiment

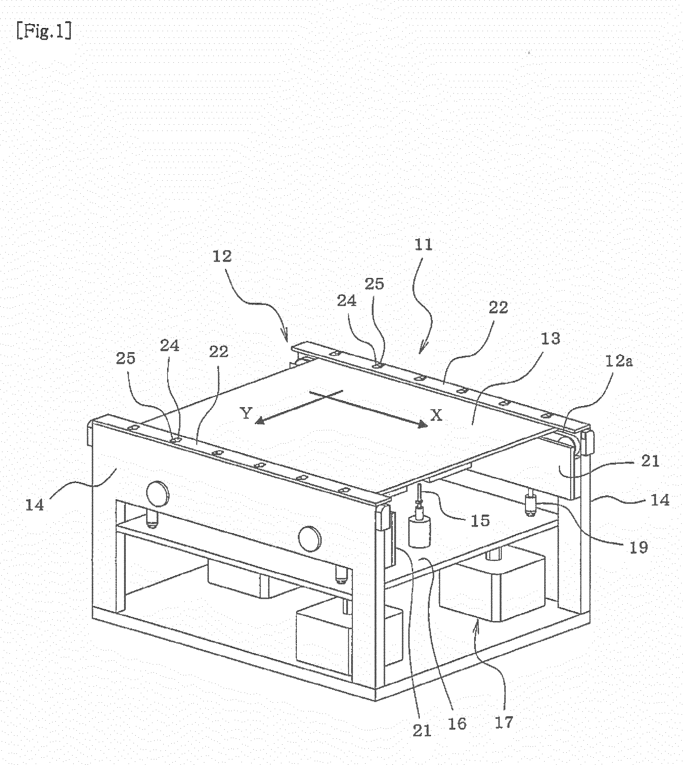

The first embodiment according to the invention will be described with reference to Figs. 1 to 6. First, a configuration of a component mounting station 11 of a component mounting machine is described with reference to Fig. 1.

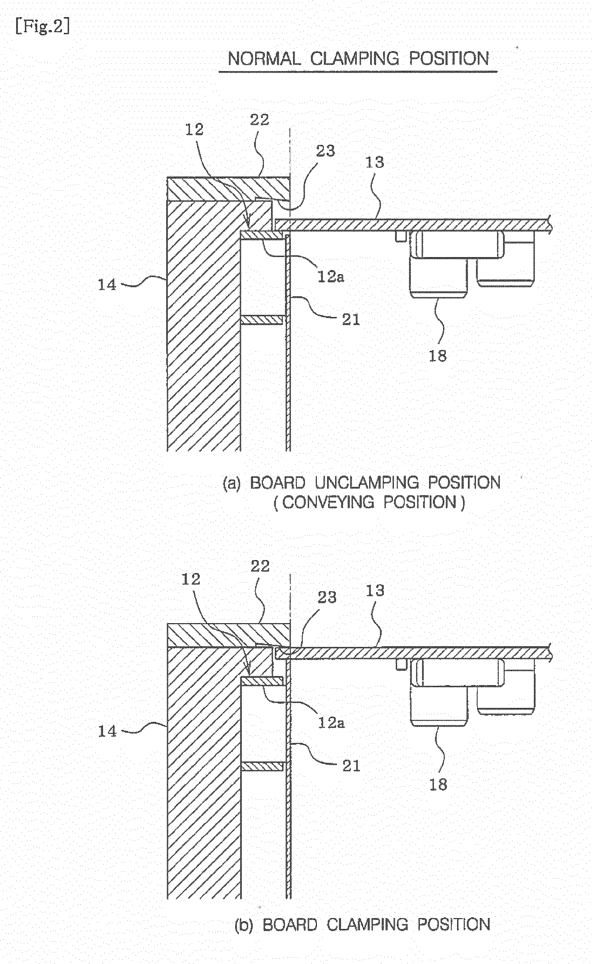

The component mounting station 11 is a place where a component is mounted on a board 13, which is conveyed in an X direction by a conveyor 12, using a mounting head (not illustrated) of the component mounting machine. The conveyor 12 includes two conveyor belts 12a (see Fig. 2) on which left and right lateral end portions of the board 13 are placed for transport. A width of the conveyor 12 (a distance between two conveyor belts 12) can be adjusted depending on a width of the board 13 by moving a guide rail 14, which holds one of the conveyor belts 12a, in the width direction (Y direction) depending on the width of the board 13.

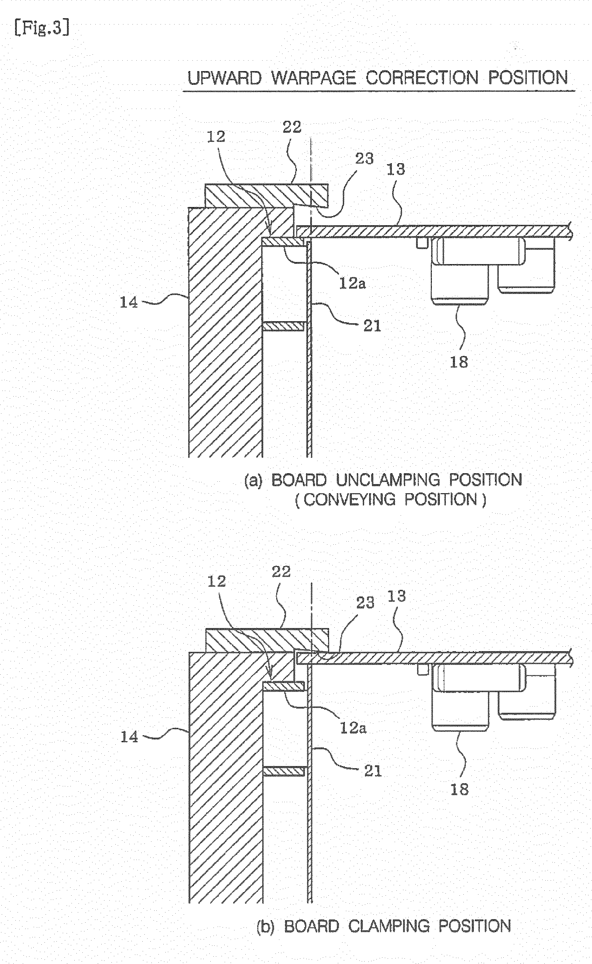

A back-up plate 16 on which a back-up pin 15 (back-up member) is disposed is horizontally disposed in the component mounting station 11. The back-up plate 16 is made of a magnetic material such as iron, and configured to attract and hold the back-up pin 15 by means of a magnet (not illustrate) at an arbitrary position on the back-up plate 16 (where the back-up pin 15 does not interfere with the pre-mounted component 18 on the lower surface of the board 13, for example) . The back-up plate 16 is moved up and down by a lifting mechanism 17. A lowest position in moving-down operation corresponds to a board unclamping position illustrated in Fig. 2 (a) and Fig. 3 (a) and a highest position in moving-up operation corresponds to a board clamping position illustrated in Fig. 2 (b) and Fig. 3 (b) .

A plate-like lifting member 21 is attached on each lateral end portion of the back-up plate 16 via a support member 19 such that the lifting member 21 is positioned on each side in the width direction of the conveyor 12 (inner side of each conveyor belt 12a). A plate-like holding member 22 is attached on an upper end of each guide rail 14 so as to protrude inwardly like a flange.

As illustrated in Fig. 2(a) and Fig. 3(a), in a state in which the back-up plate 16 is moved down to the board unclamping position, an upper end of the back-up pin 15 on the back-up plate 16 is positioned below a lower surface of the board 13 on the conveyor 12, and the upper end of the back-up pin 15 on the back-up plate 16 is positioned below the lower end of a pre-mounted component 18 on the lower surface of the board 13 when the pre-mounted component 18 is mounted on the lower surface of the board 13 on the conveyor 12.

Contrary to that, as illustrated in Fig. 2(b) and Fig. 3(b), in a state in which the back-up plate 16 is moved up to the board clamping position, the back-up pin 15 on the back-up plate 16 is moved up and the upper end of the back-up pin 15 comes in contact with the lower surface of the board 13 on the conveyor 12 to support the board 13 from below, whereby the downward warpage (downward curve) of the board 13 is prevented. When the back-up plate 16 is moved up to the board clamping position, the lifting member 21 moves up together with the back-up plate 16, and each of the left and right lateral end portions of the board 13 is clamped between the holding member 22, which is attached to the upper end of the guide rail 14, and the lifting member 21.

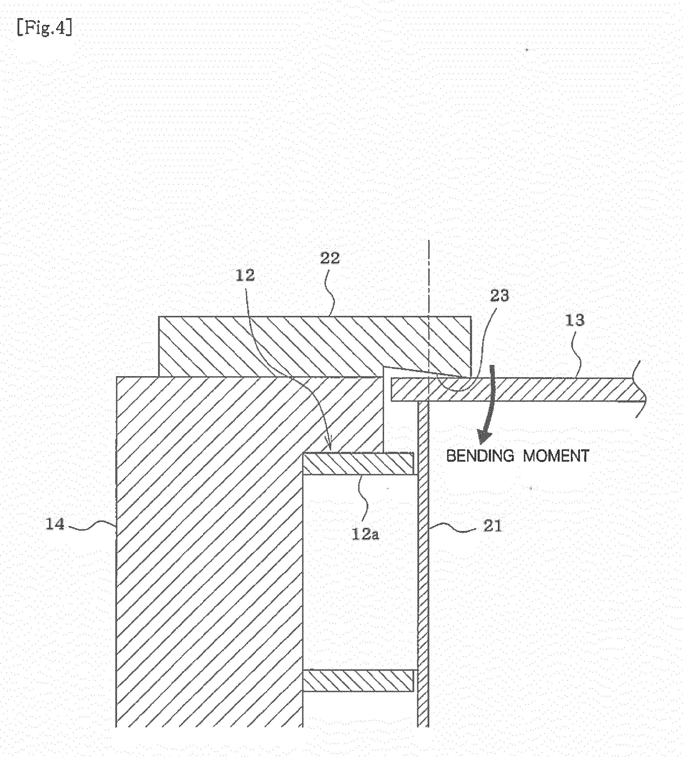

As illustrated in Fig. 4, a slope surface 23 (upward warpage correction means) is formed on a part of the lower surface of the holding member 22 that overlaps with the lateral end portion of the board 13 such that a distal end of the slope surface 23 protrudes downward. As illustrated in Fig. 2, Fig. 3, and Fig. 6, the holding member 22 is attached to be movable among the upward warpage correction position, the normal clamping position and the board removal position with respect to the guide rail 14. As illustrated in Figs. 3 and 4, at the upward warpage correction position, the distal end portion of the slope surface 23, which is the lowest part of the slope surface 23 of the holding member 22, is positioned at an inner side of the board 13 than the upper end of the lifting member 21. While such a positional relationship is maintained, the lateral end portion of the board 13 is nipped between the distal end portion of the slope surface 23 and the upper end of the lifting member 21 to clamp the board 13 in a state that downward bending moment is applied to the board 13.

On the other hand, as illustrated in Fig. 2, at the normal clamping position, the distal end portion of the slope surface 23 of the holding member 22 is positioned directly above the upper end of the lifting member 21, and there is no positional offset therebetween. While such a positional relationship is maintained, the lateral end portion of the board 13 is nipped between the distal end portion of the slope surface 23 and the upper end of the lifting member 21 to clamp the board 13 in a state that the downward bending moment is not applied to the board 13.

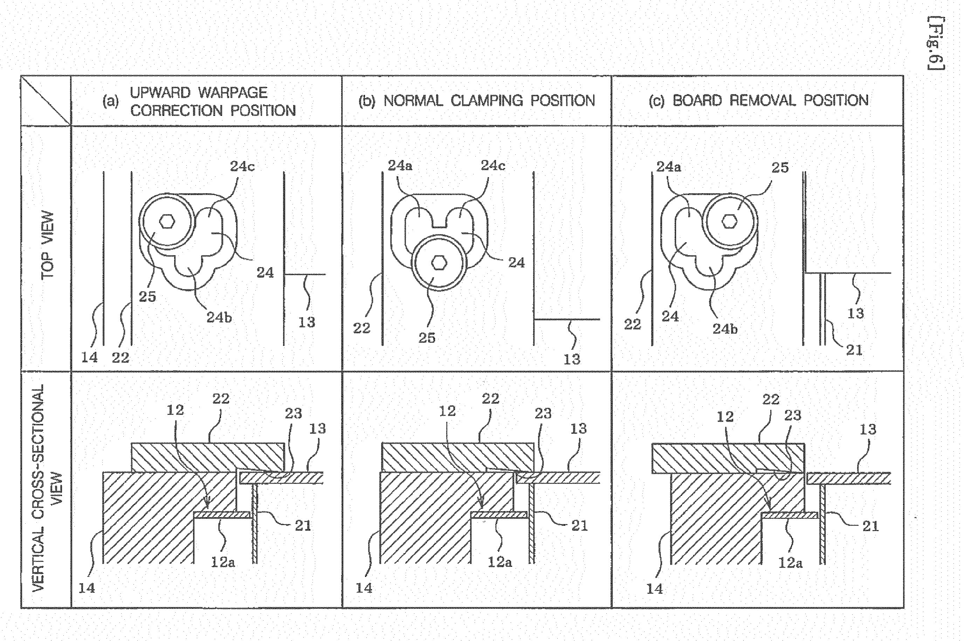

As illustrated in Fig. 6(c), the board removal position is a position where the holding member 22 is moved in a direction toward an outer side of the board 13 and the board 13 is removed upwardly in case of trouble or the like.

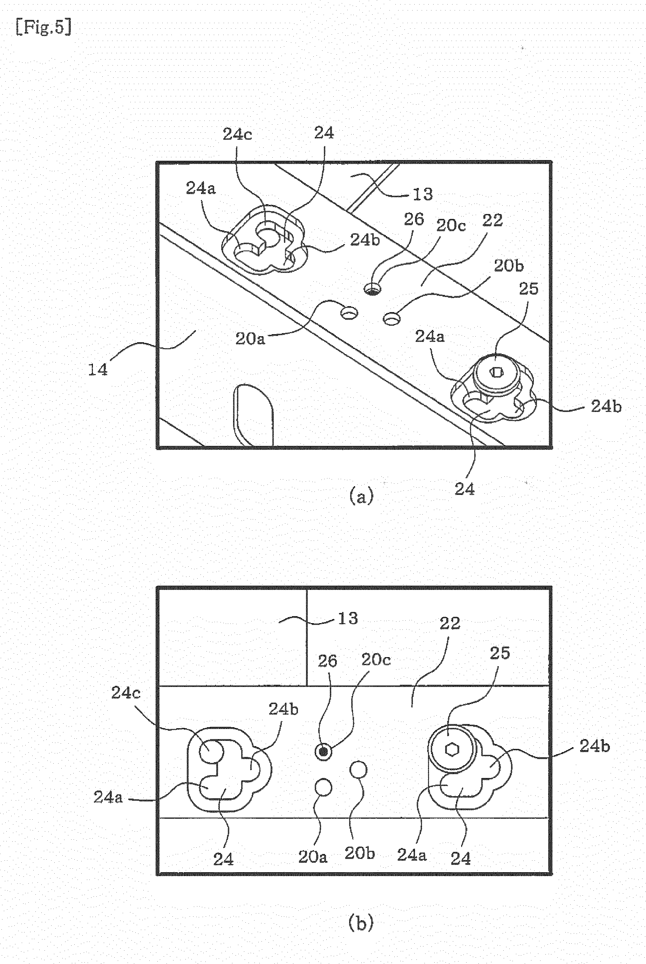

As illustrated in Figs. 5 and 6, in order to hold and engage the holding member 22 at the upward warpage correction position, the normal clamping position, or the board removal position, the holding member 22 has an engagement groove 24 such as a labyrinth groove that has engagement points 24a, 24b and 24c corresponding to the above-described three positions. The position of the holding member 22 can be switched among the upward warpage correction position, the normal clamping position and the board removal position by switching the points 24a, 24b and 24c of the engagement groove 24 to be engaged with an engagement pin 25 fixed on the upper end of the guide rail 14. In Fig. 5, two engagement grooves 24 are illustrated, but the engagement pin 25 is not illustrated in one of the engagement grooves 24.

In the first embodiment, as illustrated in Figs. 5(a), (b), the upper surface of the guide rail 14 has a position indication mark 26 (position indicator) for determining the position of the holding member 22 by image processing. The position indication mark 26 is configured such that the position indication mark 26 is aligned with and exposed in one of three through-holes 20a to 20c formed on the holding member 22 when the position of the holding member 22 is switched among the upward warpage correction position, the normal clamping position and the board removal position. Then, a camera (camera that takes an image of a fiducial mark of the board 13) of the component mounting machine takes an image of an area including the three through-holes 20a to 20c of the holding member 22, and the image is processed by an image processing device (not illustrated) of the component mounting machine to recognize the position of the through-hole through which the position indication mark 26 is exposed among the three through-holes 20a to 20c, whereby the position of the holding member 22 is determined. This allows confirmation whether the holding member 22 is moved to the correct position or not at the time of the production in advance. In this case, the presence of inclination of the holding member 22 can be determined when the position indication marks 26 are formed on the upper surface of the guide rail 14 in two or more positions along a longitudinal direction (X direction) thereof and sets of the three through-holes 20a to 20c are formed on the holding member 22 in two or more positions along the longitudinal direction (X direction) thereof, and the positions of the through-holes through which the position indication marks 26 are exposed are recognized at two or more positions by image recognition.

Alternatively, a plurality of the position indication marks (position indicator) may be formed on the upper surface of the holding member 22, an image of the position indication marks may be taken by the camera of the component mounting machine, and then the image may be processed to determine the position or the presence of inclination of the holding member 22.

Alternatively, the engagement groove 24 of the holding member 22 may be used as the position indicator, an image of the engagement groove 24 may be taken by the camera, and then the image may be processed to recognize the engagement position of the engagement pin 25 with respect to the engagement groove 24 and determine the position of the holding member 22.

Alternatively, the position indication marks may be provided on the upper surface of the guide rail 14 at positions corresponding to the upward warping correction position, the normal clamping position and the board removal position such that the position indication marks are shifted from one another in the X direction (board conveying direction), the holding member 22 may have a slit extending in the X direction through which each of the position indication marks corresponding to the upward warpage correction position, the normal clamping position and the board removal position is exposed when the holding member 22 is positioned at each of the positions, the image of the slit of the holding member 22 may be taken by the camera, and then the image may be processed to recognize the position of the position indication mark in the slit to determine the position of the holding member 22.

When the upward warpage of the board 13 is corrected by clamping the board 13 using the board clamping apparatus having the above-described configuration, an operator moves the holding member 22 to the upward warpage correction position as illustrated in Fig. 3, Fig. 4, and Fig. 6(a) such that the distal end portion of the slope surface 23 of the holding member 22 protrudes toward the inner side of the board 13 than the upper end of the lifting member 21. In this state, the board 13 is placed on the conveyor 12, and then the board 13 is conveyed to a predetermined operation position. Subsequently, the back-up plate 16 is moved up to the board clamping position and the lifting member 21 is moved up together with the back-up plate 16 so that each of the left and right lateral end portions of the board 13 is clamped between the holding member 22, which is attached to the upper end of the guide rail 14, and the lifting member 21.

At the upward warpage correction position, since the distal end portion of the slope surface 23 of the holding member 22 is positioned at the inner side of the board 13 than the upper end of the lifting member 21, the downward bending moment is applied to the board 13 when the lateral end portion of the board 13 is nipped between the distal end portion of the slope surface 23 of the holding member 22 and the upper end of the lifting member 21, thereby the upward warpage of the board 13 is corrected by the downward bending moment. At this time, the board 13 to which the downward bending moment is applied is supported by the upper end of the back-up pin 15 from below, and thus the downward warpage of the board 13 is also prevented.

When the board 13 that does not require correction is clamped, as illustrated in Fig. 2 and Fig. 6(b), an operator moves the holding member 22 to the normal clamping position such that the distal end portion of the slope surface 23 of the holding member 22 is positioned directly above the upper end of the lifting member 21 where there is no position offset therebetween. In such a sate, the board 13 is placed on the conveyor 12, and then the board 13 is conveyed to a predetermined operation position. Subsequently, the back-up plate 16 is moved up to the board clamping position and the lifting member 21 is moved up together with the back-up plate 16 so that each of the left and right lateral end portions of the board 13 is clamped between the holding member 22, which is attached to the upper end of the guide rail 14, and the lifting member 21.

At the normal clamping position, since the distal end portion of the slope surface 23 of the holding member 22 is positioned directly above the upper end of the lifting member 21 and there is no position offset therebetween, the board 13 is clamped in a state that no downward bending moment is applied to the board 13 when the lateral end portion of the board 13 is nipped between the distal end portion of the slope surface 23 of the holding member 22 and the upper end of the lifting member 21. At this time, the board 13 is supported from below by the upper end of the back-up pin 15, and thus the downward warpage (downward curve) of the board 13 is prevented.

When the holding member 22 is to be removed upwardly in case of trouble or the like, as illustrated in Fig. 6(c), an operator moves the holding member 22 to the board removal position such that the holding member 22 is positioned at a position outside the board 13 so as not to overlap with the board 13. Then, the board 13 on the conveyor 12 is removed upwardly.

According to the above-described first embodiment, the lateral end portion of the board 13 is clamped between the lifting member 21 and the holding member 22 so as to apply the downward bending moment to the board 13. Due to the downward bending moment, the upward warpage of the board 13 is reliably corrected. In addition, even when the upward warpage of the double-sided mounting board is corrected, the upward warpage correction means (slope surface 23) does not interfere with the pre-mounted component 18 on the lower side of the board 13, and the upward warpage of the board 13 is reliably corrected. Furthermore, the downward bending moment can be applied to the board 13 by clamping action of nipping the lateral end portion of the board 13 between the lifting member 21 and the holding member 22, and thus the configuration for correction of the upward warpage of the board 13 is simplified, which reduces the costs.

Furthermore, in the first embodiment, the downward bending moment can be applied to the board 13 by a simple configuration in which the slope surface 23 as the upward warpage correction means is formed at the lower surface of the holding member 22, and the distal end portion of the slope surface 23, which is the lowest portion of the slope surface 23, is shifted from the upper end of the lifting member 21, and therefore the costs can be minimized.

In such a case, if the downward bending moment applied to the board 13 is too large, the board 13 is warped downwardly beyond a flat state. However, in the first embodiment, the board 13 to which the downward bending moment is applied is supported from below by the back-up pin 15, and thus the back-up pin 15 reliably prevents the board 13 from being warped downwardly beyond a flat state by the downward bending moment applied to the board 13.

In the first embodiment, the slope surface 23 as the upward warpage correction means is formed at the lower surface of the holding member 22. However, instead of this, a distal end portion of the lower surface of the holding member 22 may be a projection protruding downwardly. Even with such a configuration, downward bending moment can be applied to the board 13 when the lateral end portion of the board 13 is clamped between the lowest portion on the distal end side of the lower surface of the holding member 22 and the upper end of the lifting member 21.

### Second Embodiment

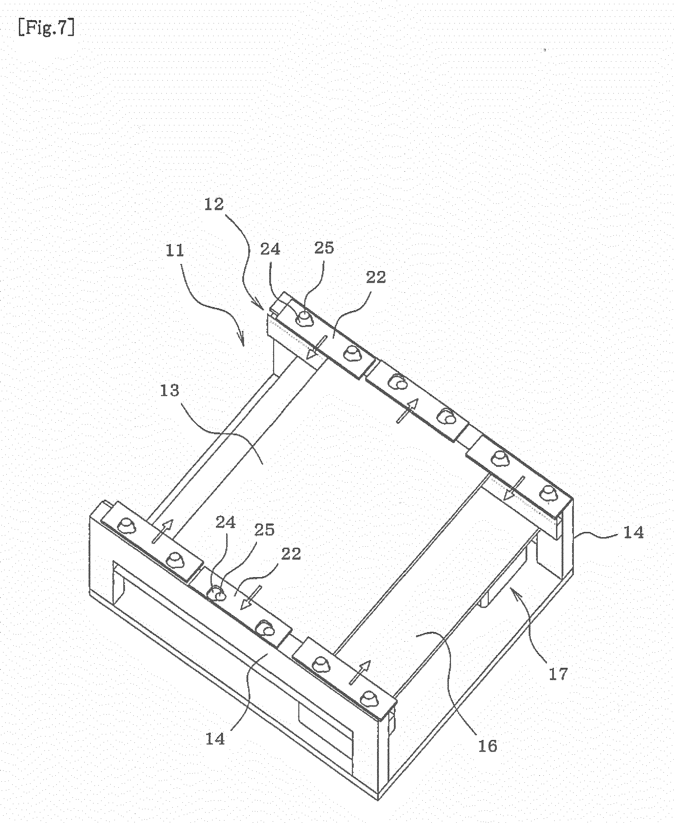

In the above-described first embodiment, one holding member 22 holds the entire area of the lateral end portion of the board 13. However, in the second embodiment of the invention illustrated in Fig. 7, a plurality of separate holding members 22 are disposed along the lateral end portion of the board 13, and each of the holding members 22 is attached to be movable among the upward warpage correction position, the normal clamping position and the board removal position individually. Each of the holding members 22 is movably attached to the upper end of the guide rail 14 by engagement between the engagement pin 25 fixed on the upper end of the guide rail 14 and the engagement groove 24. The other configurations are substantially the same as those of the above-described first embodiment.

In the above-described second embodiment, among the plurality of holding members 22 positioned along the lateral end portion of the board 13, only the holding member 22 positioned corresponding to an empty space in the lateral end portion of the board 13 is moved to the upward warpage correction position for the upward warpage correction of the board 13. This minimizes dead space made by the holding member 22.

### First related example

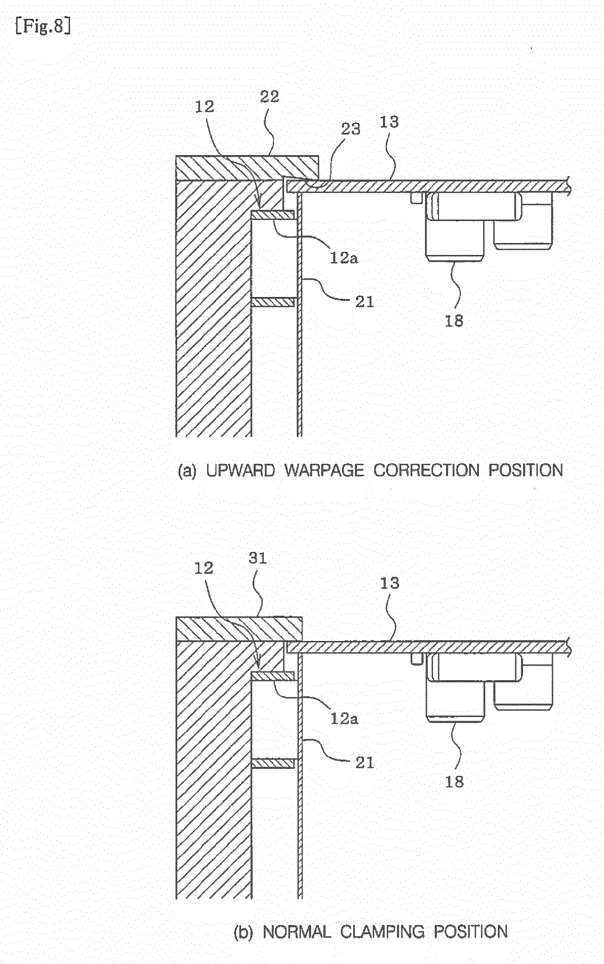

In the above-described first and second embodiments, the holding member 22 is attached to the upper end of the guide rail 14 to be movable among the upward warpage correction position, the normal clamping position and the board removal position. However, in the first related example illustrated in Fig. 8, the holding member 22 for the upward warpage correction, which clamps the board 13 in the state that the downward bending moment is applied to the board 13 in the same configuration as that of the first embodiment, and a holding member 31 for the normal clamping, which clamps the board 13 in the state that the downward bending moment is not applied to the board 13, are replaceably attached to the upper end of the guide rail 14 by an engagement means, a screw or the like. The holding member 31 for the normal clamping does not require the slope surface at its lower surface. The holding member 31 for the normal clamping is attached such that the distal end portion thereof is positioned directly above the upper end of the lifting member 21. The other configurations are substantially the same as those of the first embodiment.

The above-described first related example can also attain substantially the same effect as that of the first embodiment. Second related example

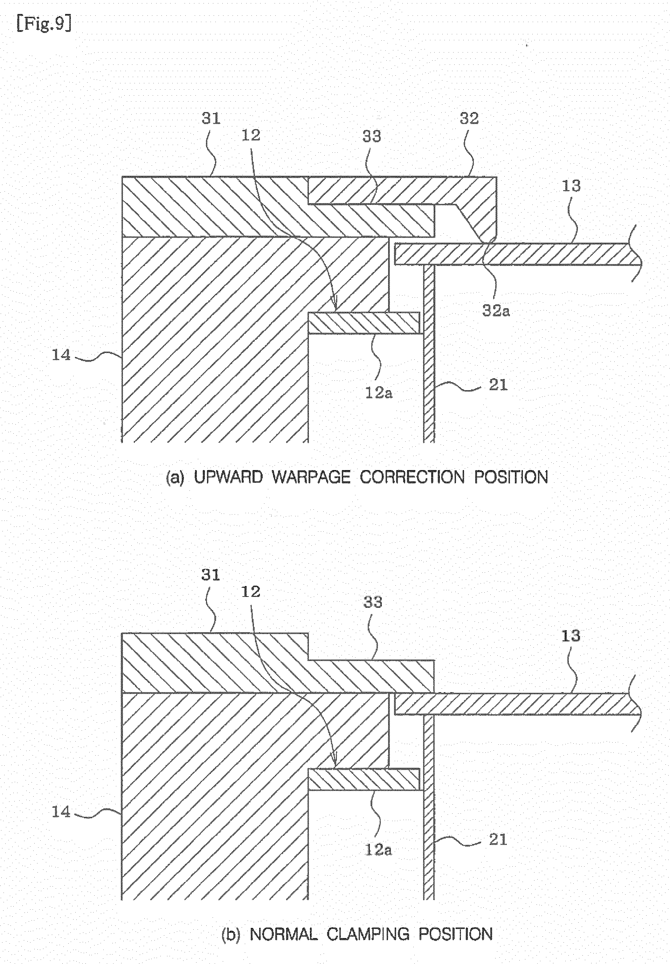

In the second related example illustrated in Fig. 9, the downward bending moment is applied to the board 13 by detachably attaching an attachment 32 for upward warpage correction, which functions as the upward warpage correction means, to the holding member 31 for the normal clamping, which clamps the board 13 in the state that the downward bending moment is not applied to the board 13, by a screw, an engagement means or the like.

The holding member 31 for the normal clamping is attached to the upper end of the guide rail 14 by an engagement means, a screw or the like, as in the first related example. The holding member 31 for the normal clamping includes a step 33 at the upper surface thereof for positioning and attaching the attachment 32 for the upward warpage correction. The attachment 32 for the upward warpage correction is detachably attached to the step 33 by a screw, an engagement means or the like. In this configuration, the holding member 31 for the normal clamping to which attachment 32 for the upward warpage correction is attached functions as the "holding member for the upward warpage correction".

As illustrated in Fig. 9(a), in a state where the attachment 32 for the upward warpage correction is attached to the holding member 31 for the normal clamping, the lowest portion 32a of the distal end portion of the attachment 32 is positioned below the lower surface of the holding member 31, and the lowest portion 32a of the distal end portion of the attachment 32 is positioned at the inner side of the board 13 than the upper end of the lifting member 21. While such a positional relationship is maintained, when the lateral end portion of the board 13 is nipped between the lowest portion 32a of the distal end portion of the attachment 32 and the upper end of the lifting member 21, the board 13 is clamped in the state that the downward bending moment is applied to the board 13.

On the other hand, as illustrated in Fig. 9(b), in a state in which the attachment 32 for the upward warpage correction is detached from the holding member 31 for the normal clamping, the distal end portion of the holding member 31 is positioned directly above the upper end of the lifting member 21. When the lateral end portion of the board 13 is nipped between the distal end portion of the holding member 31 and the upper end of the lifting member 21, the board 13 is clamped in the state that the downward bending moment is not applied to the board 13. The other configurations are substantially the same as those of the first embodiment.

The invention may be applied to a board clamping apparatus of a screen printer or any other various apparatus that conveys a board by a conveyor and clamps the board at a predetermined operation position.

### Reference Signs List

11 ... COMPONENT MOUNTING STATION, 12 ... CONVEYOR, 12a ... CONVEYOR BELT, 13 ... BOARD, 14 ... GUIDE RAIL, 15 ... BACK-UP PIN (BACK-UP MEMBER), 16 ... BACK-UP PLATE, 17 ... LIFTING MECHANISM, 18 ... PRE-MOUNTED COMPONENT, 21 ... LIFTING MEMBER, 22 ... HOLDING MEMBER, 23 ... SLOPE SURFACE (UPWARD WARPAGE CORRECTION MEANS), 24 ... ENGAGEMENT GROOVE, 25 ... ENGAGEMENT PIN, 26: POSITION INDICATION MARK (POSITION INDICATOR) , 31 ... HOLDING MEMBER FOR NORMAL CLAMPING, 32 ... ATTACHMENT FOR UPWARD WARPAGE CORRECTION

## Claims

1. A board clamping apparatus in which a board (13) conveyed by a conveyor (12) is lifted by a lifting member (21) from below at each side in a width direction of the board (13) such that a lateral end portion of the board (14) is clamped between the lifting member (21) and a holding member (22) positioned above the lifting member (21), the board clamping apparatus comprising: the holding member (22); the lifting member (21); and an upward warpage correction means (23) configured to correct upward warpage of the board (13) by applying downward bending moment to the board (13) by clamping the lateral end portion of the board (13) between the lifting member (21) and the holding member (22),
**characterized in that**
the holding member (22) is attached to be movable in the width direction between an upward warpage correction position and a normal clamping position with respect to each of guide rails (14) positioned on both sides in a width direction of the conveyor (12), and the holding member (22) is configured to clamp the board (13) in a state that the downward bending moment is applied to the board (13) by the upward warpage correction means (23) at the upward warpage correction position and clamp the board (13) in a state that the downward bending moment is not applied to the board (13) at the normal clamping position.

2. The board clamping apparatus according to Claim 1, wherein the apparatus includes: a position indicator (26) for recognizing a position of the holding member (22); a camera that takes an image of the position indicator (26); and an image processing device that processes the image taken by the camera to recognize the position indicator (26) and determine the position of the holding member (22).

3. The board clamping apparatus according to Claim 1 or 2, wherein the holding member (22) includes a plurality of separate holding members (22) disposed along the lateral end portion of the board (13), and each of the plurality of separate holding members (22) is attached to be movable between the upward warpage correction position and the normal clamping position individually.

4. The board clamping apparatus according to any one of Claims 1 to 3, wherein the upward warpage correction means (23) is configured such that a portion of a lower surface of the holding member (22,32) that overlaps with the lateral end portion of the board (13) is formed in a slope shape or a protrusion shape in which a distal end of the portion protrudes downwardly and, in a state that a lowest portion (32a) in the slope shape or the protrusion shape is positioned at an inner side of the board (13) than the upper end of the lifting member, the lateral end portion of the board (13) is nipped between the lowest portion (32a) and the upper end of the lifting member (21) so that the downward bending moment is applied to the board.

## Patentansprüche

1. Platten-Einspannvorrichtung, bei der eine mittels einer Fördereinrichtung (12) beförderte Platte (13) mit einem Anhebe-Element (21) an jeder Seite in einer Breitenrichtung der Platte (13) von unten so angehoben wird, dass ein seitlicher Endabschnitt der Platte (14) zwischen dem Anhebe-Element (21) und einem oberhalb des Anhebe-Elementes (21) positionierten Halte-Element (22) eingespannt wird, wobei die Platten-Einspannvorrichtung das Halte-Element (22), das Anhebe-Element (21) sowie eine Einrichtung (23) zur Korrektur von Verzug nach oben umfasst, die so eingerichtet ist, dass sie Verzug der Platte (13) nach oben korrigiert, indem sie durch Einspannen des seitlichen Endabschnitts der Platte (13) zwischen dem Anhebe-Element (21) und dem Halte-Element (22) nach unten gerichtetes Biegemoment auf die Platte (13) ausübt,
**dadurch gekennzeichnet, dass**
das Halte-Element (22) so angebracht ist, dass es in der Breitenrichtung zwischen einer Position zur Korrektur von Verzug nach oben und einer normalen Einspann-Position in Bezug auf jede von Führungsschienen (14) bewegt werden kann, die an beiden Seiten in einer Breitenrichtung der Fördereinrichtung (12) positioniert sind, und das Halte-Element (22) so eingerichtet ist, dass es an der Position zur Korrektur von Verzug nach oben die Platte (13) in einem Zustand einspannt, in dem das nach unten gerichtete Biegemoment durch die Einrichtung (23) zur Korrektur von Verzug nach oben auf die Platte (13) ausgeübt wird, und an der normalen Einspann-Position die Platte (13) in einem Zustand einspannt, in dem das nach unten gerichtete Biegemoment nicht auf die Platte (13) ausgeübt wird.

2. Platten-Einspannvorrichtung nach Anspruch 1, wobei die Vorrichtung eine Positionsanzeige (26) zum Erkennen einer Position des Halte-Elementes (22), eine Kamera, die ein Bild der Positionsanzeige (26) aufnimmt, sowie eine Bildverarbeitungseinrichtung enthält, die das von der Kamera aufgenommene Bild verarbeitet, um die Positionsanzeige (26) zu erkennen und die Position des Halte-Elementes (22) zu bestimmen.

3. Platten-Einspannvorrichtung nach Anspruch 1 oder 2, wobei das Halte-Element (22) eine Vielzahl separater Halte-Elemente (22) einschließt, die entlang des seitlichen Endabschnitts der Platte (13) angeordnet sind, und jedes der Vielzahl separater Halte-Elemente (22) so angebracht ist, dass es individuell zwischen der Position zur Korrektur von Verzug nach oben und der normalen Einspann-Position bewegt werden kann.

4. Platten-Einspannvorrichtung nach einem der Ansprüche 1 bis 3, wobei die Einrichtung (23) zur Korrektur von Verzug nach oben so eingerichtet ist, dass ein Abschnitt einer Unterseite des Halte-Elementes (22, 32), der sich mit dem seitlichen Endabschnitt der Platte (13) überlappt, in einer Abschrägungs-Form oder Vorsprungs-Form ausgebildet ist, bei der ein vorderes Ende des Abschnitts nach unten vorsteht und, in einem Zustand, in dem ein unterster Abschnitt (32a) an der Abschrägungs-Form oder der Vorsprungs-Form an einer weiter innen liegenden Seite der Platte (13) als das obere Ende des Hebe-Elementes positioniert ist, der seitliche Endabschnitt der Platte (13) zwischen dem untersten Abschnitt (32a) und dem oberen Ende des Hebe-Elementes (21) so eingeklemmt ist, dass das nach unten gerichtete Biegemoment auf die Platte ausgeübt wird.

## Revendications

1. Appareil de blocage de carte dans lequel une carte (13), transportée par convoyeur (12), est levée grâce à un élément de levage (21) depuis le dessous sur chaque côté dans la direction de la largeur de la carte (13) de sorte à ce qu'une extrémité latérale de la carte (14) soit bloquée entre l'élément de levage (21) et un élément de maintien (22) positionné au-dessus de l'élément de levage (21), l'appareil de blocage de carte comprenant : l'élément de maintien (22), l'élément de levage (21) et un moyen de correction de voilage vers le haut (23) configuré pour corriger le voilage vers le haut de la carte (13) en appliquant un moment de cintrage vers le bas à la carte (13) en bloquant l'extrémité latérale de la carte (13) entre l'élément de levage (21) et l'élément de maintien (22),
**caractérisé en ce que**
l'élément de maintien (22) est fixé pour être mobile dans la direction de la largeur entre une position de correction de voilage vers le haut et une position normale de blocage par rapport à chacun de rails de guidage (14) positionnés des deux côtés dans la direction de la largeur du convoyeur (12) ; et l'élément de maintien (22) est configuré pour bloquer la carte (13) de telle sorte que le moment de cintrage vers le bas soit appliqué sur la carte (13) par le moyen de correction de voilage vers le haut (23) au niveau de la position de correction de voilage vers le haut, ainsi que pour bloquer la carte (13) de telle sorte que le moment de cintrage vers le bas ne soit pas appliqué sur la carte (13) au niveau de la position normale de blocage.

2. Appareil de blocage de carte selon la revendication 1, l'appareil incluant : un indicateur de position (26) permettant de reconnaître la position de l'élément de maintien (22), un appareil de prise de vues qui prend une image de l'indicateur de position (26) et un dispositif de traitement d'image qui traite l'image prise par l'appareil de prise de vues afin d'identifier l'indicateur de position (26) et de déterminer la position de l'élément de maintien (22).

3. Appareil de blocage de carte selon la revendication 1 ou la revendication 2, dans lequel l'élément de maintien (22) inclut une pluralité d'éléments de maintien (22) séparés disposés le long de l'extrémité latérale de la carte (13), et chacun de la pluralité d'éléments de maintien (22) séparés est fixé pour être mobile individuellement entre la position de correction de voilage vers le haut et la position normale de blocage.

4. Appareil de blocage de carte selon l'une quelconque des revendications 1 à 3, dans lequel le moyen de correction de voilage vers le haut (23) est configuré de sorte à ce qu'une partie de la surface inférieure de l'élément de maintien (22, 32) qui chevauche l'extrémité latérale de la carte (13) prenne la forme d'une pente ou d'une protubérance dans laquelle l'extrémité distale de la partie dépasse vers le bas et, dans un état où la partie la plus basse (32a) de la forme de pente ou de la forme de protubérance est positionnée au niveau du côté interne de la carte (13) par rapport à l'extrémité supérieure de l'élément de levage, l'extrémité latérale de la carte (13) est pincée entre la partie la plus basse (32a) et la partie supérieure de l'élément de levage (21) de sorte à ce que le moment de cintrage vers le bas soit appliqué sur la carte.
